# EUROPÄISCHE PATENTANMELDUNG

(11) **EP 0 917 178 A1**
(43) Veröffentlichungstag der Anmeldung: **19.05.1999**
(21) Anmeldenummer: 97120123.1
(22) Anmeldetag: 17.11.1997
(51) Int. Cl.: H01J 37/244

(54) **Detektor für Sekundärkorpuskeln und dessen Anordnung in einem Korpuskularstrahlgerät**

(71) Anmelder: ICT Integrated Circuit Testing Gesellschaft für Halbleiterprüftechnik mbH, 85551 Heimstetten (DE)
(72) Erfinder: Feuerbaum, Hans-Peter, Dr., 81739 München (DE); Winkler, Dieter, Dr., 81739 München (DE); Baumgarten, Holger, Dipl.-Ing., 85567 Bruck (DE)
(74) Vertreter: DIEHL GLAESER HILTL & PARTNER

(57) **Zusammenfassung**

Die Erfindung lehrt einen Detektor (11) für Sekundärkorpuskeln (SE) sowie dessen Anordnung in einem Korpuskularstrahlgerät (1). Der Detektor (11) für Sekundärkorpuskeln (SE) ist im Strahlengang der Primärkorpuskeln angeordnet und trägt eine Szintillationsschicht (16) zur Erzeugung von Photonen (30; 32, 34, 36), die ihrerseits ausgewertet werden. Dabei sind die Szintillationsschicht (16) und ihr Träger (14) im Bereich der Durchgangsöffnung (18) sehr dünn ausgebildet, so daß der Primärstrahl (PE) nur sehr gering beeinflußt wird, selbst wenn die Durchgangsöffnung (18) sehr eng ausgebildet ist. Durch die enge Ausbildung der Durchgangsöffnung (18) können auch achsnahe Sekundärelektronen gut erfaßt werden.

## Beschreibung

Die Erfindung betrifft einen Detektor für Sekundärkorpuskeln mit einer Szintillationsschicht, zur Erzeugung von Photonen beim Auftreffen der Sekundärkorpuskeln, und einem Träger für die Szintillationsschicht, die mit einer Durchgangsöffnung für den Primärstrahl versehen sind, und einer Detektionseinrichtung zum Aufnehmen, Fühlen und Auswerten der Photonen.

Ein solcher Detektor ist aus der EP 0 274 622 (B1) bekannt.

Derartige Detektoren werden insbesondere in Korpuskularstrahlgeräten, in denen Korpuskeln (meistens Elektronen, aber auch Protonen, Ionen und andere elektrisch geladene Teilchen) unter Verwendung einer Teilchenoptik von einer entsprechenden Quelle (z. B. einer Kathode) auf ein Ziel gelenkt werden, eingesetzt.

Bei einer bestimmten Klasse von Korpuskularstrahlgeräten werden die, von auf eine Probe auftreffenden (dann: Primär-) Korpuskeln ausgelösten Sekundärkorpuskeln gefühlt (detektiert) und zur Erlangung von Informationen über die Probe ausgewertet. Ein Beispiel ist das Raster-Elektronenmikroskop, bei dem ein möglichst fein (im Nanometerbereich) durch die Elektronenoptik fokussierter Elektronenstrahl durch eine zusätzliche Ablenkeinrichtung über die Probe geführt wird. Nachfolgend wird meist von Elektronen statt allgemein von Korpuskeln gesprochen. Die Erfindung ist jedoch nicht auf Elektronen beschränkt.

Dabei ist bei manchen Geräten der Detektor seitlich der Probe angeordnet und die Sekundärelektronen werden durch ein Ablenkfeld in der Probenkammer auf den Detektor gelenkt. Dies erfordert einen Mindestabstand zwischen dem Objektiv der Elektronenoptik und der Probe, was die Auflösung verschlechtert. Ferner kann das Ablenkfeld die Auflösung des Primärstrahls verschlechtern.

Es ist auch schon bekannt, einen Detektor oberhalb des Objektivs seitlich anzuordnen. Dabei werden die Sekundärlektronen in der elektronenoptischen Säule durch ein Wien-Filter (Überlagerung eines magnetischen und eines elektrostatischen Feldes) seitlich auf den Detektor abgelenkt. Dabei kann das kombinierte elektrostatisch-magnetische Feld so dimensioniert werden, daß die Primärelektronen nicht beeinflußt werden. Jedoch ist die Realisierung sehr aufwendig und eine sehr genaue Abstimmung des Systems ist erforderlich, um eine Beeinflussung des Primärstrahls zu vermeiden.

Bei einem Detektor der eingangs angegebenen Gattung werden die Sekundärelektronen auf eine sehr dünne, Photonen abstrahlende Szintillationsschicht gelenkt, die auf einer auch als Träger für die Szintillationsschicht dienenden, von der Seite der Sekundärelektronen abgewandt angeordneten Detektionseinrichtung für die Photonen aus der Szintillationsschicht aufgebracht ist. Der eingangs angegebene Detektor wird oberhalb des Objektives in den Strahlengang des Primärstrahls gebracht. Dies erfordert allerdings eine zentrale zylindrische Öffnung für den Durchgang des Primärstrahls durch den Detektor zur Probe. Nachteilig ist daran insbesondere, daß die zentrale zylindrische Öffnung relativ groß (Durchmesser ca. 2 mm) gewählt werden muß, damit eine Kontamination der Innenwände des entstehenden Zylinders, die zu störenden Aufladungen oder gar Ausblendungen des Primärstrahls führen kann, vermieden werden kann.

Der (aus Symmetriegründen in der Regel zylindrische) Bereich um die Primärstrahlachse, außerhalb dessen Bestandteile des Detektors gehalten werden müssen (z. B. beim eingangs angegebenen Detektor mit Szintillator oder auch bei einer Multichannelplatte), wird hier als "Störbereich" bezeichnet.

Die benötigte große Öffnung im Störbereich führt nun wieder dazu, daß gerade die in der Umgebung der optischen Achse des Primärstrahls fliegenden Sekundärlektronen, und damit ein großer Teil der Sekundärelektronen, auf den zylindrischen Durchgang treffen und damit für die Auswertung verlorengehen.

Aufgabe der Erfindung ist es daher, einen Detektor der angegebenen Gattung zu schaffen, bei dem die Sekundärelektronen mit hoher Ausbeute, d. h. möglichst vollständig, und ohne Beeinträchtigung des Primärstrahls detektiert werden können.

Dies wird erfindungsgemäß dadurch erreicht, daß der Träger für die Szintillationsschicht zumindest in einem zylindrischen Störbereich um die Durchgangsöffnung als sehr dünne Trägerplatte ausgebildet ist, die Szintillationsschicht als sehr dünne Schicht ausgebildet ist, die Durchgangsöffnung für den Primärstrahl als sehr enge Öffnung ausgebildet ist, und der Eintrittsbereich der Detektionseinrichtung für die Photonen auch aus dem durch den Störbereich definierten ringförmigen Bereich der Szintillationsschicht, radial außerhalb des Störbereichs für den Primärstrahl (PE) angeordnet ist.

Das Verhältnis von Durchmesser zu Höhe der Durchgangsöffnung beträgt bevorzugt ca. 1:3, besonders bevorzugt mindestens 1:3.

Die Dicke der Trägerplatte ist nach unten nur durch des Erfordernis einer gewissen mechanischen Festigkeit und Handhabbarkeit begrenzt und dadurch, daß die Szintillationsschicht aufgebracht werden muß.

Dadurch, daß der die Szintillationsschicht tragende Träger in den Störbereich hineinragen gelassen wird, wird es möglich, auch die zum Primärstrahl achsnahen Sekundärelektronen für die Szintillation zu erfassen. Da der Träger jedoch erfindungsgemäß (zumindest) dort extrem dünn ausgebildet ist, sind die Wände des verbleibenden Durchgangszylinders für den Primärstrahl so klein, daß, wie sich herausgestellt hat, sie den Primärstrahl trotz der größeren Nähe nicht negativ beeinflussen.

Dadurch, daß der Eintrittsbereich der Detektionseinrichtung für die von der zusätzlichen Szintillationsfläche kommenden Photonen außerhalb des Störbereichs liegt, ist auch von dorther keine Beeinträchtigung des Primärstrahls zu erwarten.

Gegebenenfalls braucht nicht zusätzlich ein neues Element in die Teilchenoptik eingebracht zu werden, vielmehr kann die Schicht auf vorhandene bzw. ohnehin notwendige Blenden für den Primärstrahl aufgebracht werden.

Bevorzugt ist der Eintrittsbereich durch einen, in den durch den Radius der Szintillationsschicht definierten Zylinder um den Primärstrahl ragenden, Lichtleiter gebildet.

Ein solcher Lichtleiter, der bevorzugt in einem Abstand von mehreren Millimetern zum Primärstrahl, derart, daß der Primärstrahl nicht beeinflußt wird, angeordnet ist, registriert, d. h. nimmt auf und leitet weiter, einen entsprechenden Teil der von den Sekundärelektronen ausgelösten Photonen. Einerseits schirmt er nur einen Teil de Sekundärelektronen ab, andererseits führt die Tatsache, daß nur ein Teil der ausgelösten Photonen registriert wird, nicht zu einer Verschlechterung des Signal-Rausch-Verhältnisses, da ein Sekundärelektron typischerweise 200-500 Photonen erzeugt.

Bevorzugt ist der Lichtleiter als Lichtleitstab (20) ausgebildet.

Dafür treffen die eben genannten Vorteile insbesondere zu.

Bevorzugt besteht die Trägerplatte aus Molybdän oder einer Molybdänlegierung oder auch Platin. Diese Materialien haben sich hierfür besonders bewährt.

Bevorzugt ist der Träger für Photonen aus der Szintillationsschicht durchlässig und ist zumindest der Photoneneintrittsbereich der Detektionseinrichtung im Halbraum des Trägers angeordnet.

Bei einer entsprechend dünnen Szintillationsschicht treten die durch die Sekundärelektronen ausgelösten Photonen auch nach hinten durch die Schicht hindurch und können dann durch die Trägerplatte hindurchtreten und in einen entsprechend angeordneten Eintrittsbereich einer Detektionseinrichtung für die Photonen des Detektors eintreten. Dadurch wird zusätzliche Freiheit bei der Anordnung der Bestandteile des Detektors gewonnen.

Bevorzugt liegt der Durchmesser der Durchgangsöffnung für den Primärstrahl zwischen 5 und 200 µm,

Dies wird, wie schon oben ausgeführt, durch die geringe Dicke der Trägerplatte mit Szintillationsschicht möglich und hat den Vorteil, daß der Durchmesser der Öffnung zwischen zwei und drei Größenordnungen kleiner ist als bei herkömmlichen Geräten, also die Fläche, durch die Sekundärelektronen ungenutzt, ohne Erzeugung von Photonen, entweichen können, um vier bis sechs Größenordnungen kleiner ist.

Besonders bevorzugt liegt der Durchmesser der Öffnung zwischen 10 und 50 µm. Dieser Bereich hat sich als optimal für die Erfordernisse einfacher Herstellung bei Beibehaltung der geschilderten Vorteile herausgestellt.

Bevorzugt liegt die Dicke der Trägerplatte im µm-Bereich.

Bevorzugt liegt die Dicke der Trägerplatte zwischen 1 und 100 µm, besonders bevorzugt zwischen 1 und 10 µm.

Bei diesen Dicken, und unter Berücksichtigung der Tatsache, daß die Dicke der Beschichtung nur wenige µm trägt, wird der Primärelektronenstrahl praktisch nicht beeinträchtigt.

Bevorzugt sind Szintillationsschicht und Trägerplatte integral ausgebildet, z. B. als Folie mit szintillierenden Bestandteilen.

Die Erfindung betrifft auch ein Korpuskularstrahlgerät mit einer Quelle zur Erzeugung der Primärkorpuskeln im Primärstrahl, einer Probe, auf die Primärkorpuskeln unter Erzeugung von Sekundärekorpuskeln auftreffen, und einer Teilchenoptik, um die Korpuskeln von der Quelle auf die Probe zu lenken. Dies ist das bevorzugte Einsatzgebiet eines Detektors mit den oben beschriebenen Merkmalen.

Dabei ist ein solcher Detektor im Strahlengang des Primärstrahls des Korpuskularstrahls des Korpuskularstrahlgerätes angeordnet. Die Anordnung erfolgt selbstverständlich so, daß die Achse des Korpuskularstrahls durch die Durchgangsöffnung hindurchgeht.

Bevorzugt ist der Detektor in Strahlrichtung der Primärkorpuskeln vor dem Objektiv der Teilchenoptik angeordnet.

Dies ist einerseits aus Raumgründen zweckmäßig, und ferner fokussiert das Objektiv auch Sekundärkorpuskeln, z. B. Sekundärelektronen.

Bevorzugt ist die Szintillationsschicht auf einer Aperturblende für den Primärstrahl aufgebracht. Falls diese die entsprechenden Anforderungen erfüllt, bzw. im Rahmen der erfindungsmäßigen Ausgestaltung so abgebildet wird, ist kein gesonderter Träger für die Szintillationsschicht erforderlich, was Raum spart und den Gesamtaufbau des Korpuskularstrahlgerätes vereinfacht.

Nachfolgend wird die Erfindung anhand einer bevorzugten Ausführungsform unter Bezugnahme auf die beigefügten Zeichnungen, auf die wegen Ihrer Klarheit und Übersichtlichkeit hinsichtlich der Offenbarung ausdrücklich verwiesen wird, noch näher erläutert. Es zeigen:
- Fig. 1: schematisch die Gesamtanordnung des erfindungsgemäßen Korpuskularstrahlgerätes.
- Fig. 2: schematisch mehr im Einzelnen den erfindungsgemäßen Szintillations-Detektor.

Das insgesamt mit 1 bezeichnete Korpuskularstrahlgerät weist eine Quelle, im vorliegenden Falle eine Elektronen aussendende Kathode 2 auf, die auf -1 kV liegt.

Die Elektronenoptik weist eine Wehnelt-Elektrode 4, die beispielsweise auf -1,5 kV liegt, eine Absaugelektrode 6, die auf ca. + 3 kV liegt und eine Anode 8 auf.

Die Anode 8 liegt auf ca. + 10 kV.

Der Elektronenstrahl tritt in ein Rohr 10 (Durchmesser ca. 12 mm) aus nichtferromagnetischem Material ein, das das Potential der Anode 8 aufweist.

Den oberen Bereich des Rohres umgibt der Kondensor 12, der den Primärelektronenstrahl PE (hier nur schematisch gezeigt) bündelt.

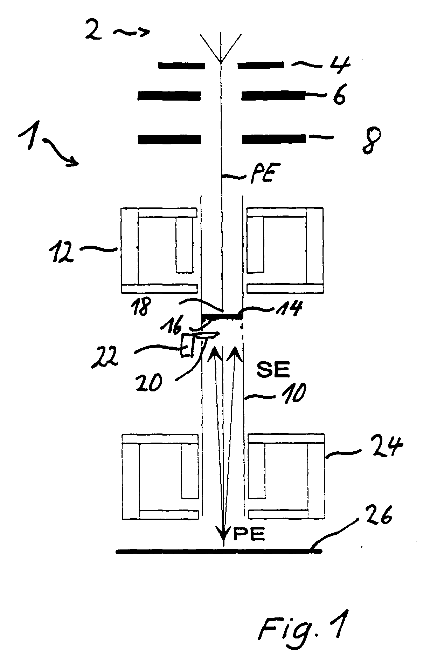

An der Stelle einer Aperturblende befindet sich die erfindungsgemäße Trägerplatte 14, auf deren in Fig. 1 nach unten gerichteten Seite die Szintillationsschicht 16 aufgebracht ist. Der Träger 14 hat eine Dicke von 10 µm, die Szintillationsschicht eine Dicke von 5 µm. Durch beide geht eine konzentrische, fluchtende Öffnung 18 für den Primärelektronenstrahl PE mit dem Durchmesser von 10 µm hindurch. Unterhalb der Szintillationsschicht befindet sich der Lichtleitstab 20, der die Photonen von der Szintillatorbeschichtung zu einem Photomultiplier 22 weiterleitet, wo sie weiterverstärkt und ausgewertet werden.

Die Anordnung aus Trägerplatte 14, Szintillationsbeschichtung 16, der Durchgangsöffnung 18 für den Primärelektronenstrahl und dem Lichtleiterstab 20 liegt oberhalb des Objektives 24, das den Primärelektronenstrahl PE auf der Probe 26, die auf einem Potential von 0 Volt liegt, fokussiert.

Die auf der Probe 26 ausgelösten Sekundärelektronen SE treten entgegen der Richtung der Primärelektronen PE in das Rohr 10 und damit in das dieses umgebende Objektiv 24 ein und gelangen auf die Szintillationsschicht 16, wo sie die auf den Lichtleiter 20 treffenden Photonen auslösen. Wegen der kleinen Fläche des Loches 18 wird nur ein verschwindend geringer Teil der Sekundärelektronen durch diese Öffnung verloren gehen.

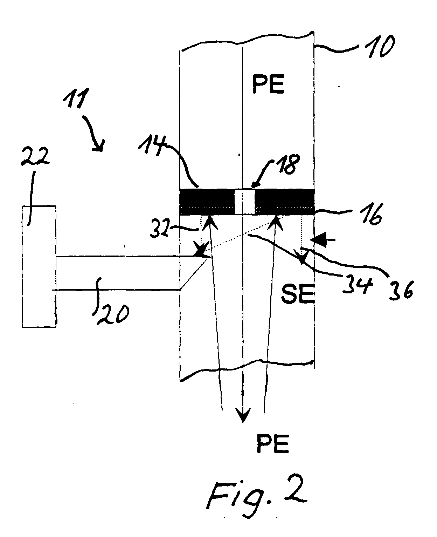

Fig. 2 zeigt die in Fig. 1 im Rahmen der Gesamtanordnung gezeigte erfindungsgemäße Teilanordnung mehr im Einzelnen.

Der schematisch bei PE angeordnete Primärelektronenstrahl verläuft im schon erwähnten Rohr 10 und tritt, je nach seiner Dicke an dieser Stelle, ausgeblendet oder ungehindert durch die enge, niedrige Durchlaßöffnung 18. Die Trägerplatte 14 mit der Szintillatorbeschichtung 16 ist gleichzeitig eine Aperturblende im elektronenoptischen Strahlengang.

Durch die Sekundärelektronen SE ausgelöste Photonen 30 (beispielhafte Bahnen sind mit 32, 34 und 36 bezeichnet) treffen zumindest teilweise auf den Lichtleiter 20 und werden von diesem zum Photomultiplier 22 geleitet. Der Lichtleiter 20 dient auch dazu, den spannungsempfindlichen Photomultiplier vom auf dem Potential der Anode 8 liegenden Rohr 10 bzw. der ebenfalls auf diesem Potential liegenden Trägerplatte mit Szintillatorbeschichtung, 14 bzw. 16, entferntzuhalten.

## Patentansprüche

1. Detektor (11) für Sekundärkorpuskeln mit
einer Szintillationsschicht (16), zur Erzeugung von Photonen (30; 32, 34, 36) beim Auftreffen der Sekundärkorpuskeln (SE), und
einem Träger (14) für die Szintillationsschicht (16),
die (14; 16) mit einer Durchgangsöffnung (18) für den Primärstrahl (PE) versehen sind, und
einer Detektionseinrichtung (20, 22) zum Aufnehmen, Fühlen und Auswerten der Photonen (30; 32, 34, 36),
dadurch gekennzeichnet, daß
der Träger für die Szintillationsschicht (16) zumindest in einem zylindrischen Störbereich um die Durchgangsöffnung (18) als sehr dünne Trägerplatte (14) ausgebildet ist,
die Durchgangsöffnung für den Primärstrahl (PE) als sehr enge Öffnung (18) ausgebildet ist, und
der Eintrittsbereich der Detektionseinrichtung (10, 22), für die Photonen auch aus dem durch den Störbereich definierten ringförmigen Bereich der Szintillationsschicht (14), radial außerhalb des Störbereichs für den Primärstrahl (PE) angeordnet ist.

2. Detektor nach Anspruch 1, dadurch gekennzeichnet, daß
das Verhältnis von Durchmesser zu Höhe der Durchgangsöffnung (18) ca. 1:3, bevorzugt mindestens 1:3, beträgt.

3. Detektor nach Anspruch 1 oder 2, dadurch gekennzeichnet, daß
der Eintrittsbereich durch einen, in den Radius der Szintillationsschicht definierten Zylinder um den Primärstrahl ragenden, Lichtleiter (20) gebildet ist.

4. Detektor nach Anspruch 3, dadurch gekennzeichnet, daß
der Lichtleiter als Lichtleitstab (20) ausgebildet ist.

5. Detektor nach einem der Ansprüche 1 bis 4, dadurch gekennzeichnet, daß
die Trägerplatte (14) aus Molybdän, einer Molybdänlegierung, oder Platin besteht.

6. Detektor nach einem der Ansprüche 1 bis 4, dadurch gekennzeichnet, daß
der Träger (14) für Photonen aus der Szintillationsschicht (16) durchlässig ist und zumindest der Photoneneintrittsbereich der Detektionseinrichtung (20, 22) im Halbraum des Trägers (14) angeordnet ist.

7. Detektor nach einem der Ansprüche 1 bis 6, dadurch gekennzeichnet, daß
der Durchmesser der Durchgangsöffnung (18) für den Primärstrahl zwischen 5 und 200 µm liegt.

8. Detektor nach Anspruch 7, dadurch gekennzeichnet, daß
der Durchmesser der Öffnung (18) zwischen 10 und 50 µm liegt.

9. Detektor nach einem der Ansprüche 1 bis 8, dadurch gekennzeichnet, daß
die Dicke der Trägerplatte (14) im µm-Bereich liegt.

10. Detektor nach Anspruch 9, dadurch gekennzeichnet, daß
die Dicke der Trägerplatte (14) zwischen 1 und 100 µm, besonders bevorzugt zwischen 1 und 10 µm liegt.

11. Detektor nach einem der vorhergehenden Ansprüche, dadurch gekennzeichnet, daß Szintillationsschicht und Trägerplatte integral ausgebildet sind.

12. Korpuskularstrahlgerät (1) mit
einer Quelle (2) zur Erzeugung der Primärkorpuskeln im Primärstrahl (PE),
einer Probe (26), auf die Primärkorpuskeln unter Erzeugung von Sekundärkorpuskeln (SE) auftreffen, und
einer Teilchenoptik (4; 6; 8; 10; 12; 14, 18, 24), um die Korpuskeln von der Quelle (2) auf die Probe (26) zu lenken,
gekennzeichnet durch
die Anordnung eines Detektors nach einem der Ansprüche 1 bis 11 im Strahlengang des Primärstrahls (PE).

13. Korspuskularstrahlgerät nach Anspruch 12, dadurch gekennzeichnet, daß
der Detektor (11) in Strahlrichtung der Primärkorpuskeln (PE) vor dem Objektiv (24) der Teilchenoptik (4; 6; 8; 10; 12; 14, 18; 24) angeordnet ist.

14. Korpuskularstrahlgerät nach einem der Ansprüche 12 oder 13,
dadurch gekennzeichnet, daß
die Szintillationsschicht (16) auf einer Aperturblende (14) für den Primärstrahl (PE) aufgebracht ist.
